# EUROPEAN PATENT SPECIFICATION

(11) **EP 0 876 091 B1**
(45) Date of publication and mention of the grant of the patent: **19.03.2003**
(21) Application number: 96942652.7
(22) Date of filing: 26.12.1996
(51) Int. Cl.: H05K 13/02, H05K 13/04

(54) **PART SUPPLYING DEVICE**
ZUFÜHREINRICHTUNG FÜR BAUTEILE
DISPOSITIF D'ALIMENTATION EN ELEMENTS

(30) Priority: 28.12.1995 JP 34282295
(43) Date of publication of application: 04.11.1998
(73) Proprietor: MATSUSHITA ELECTRIC INDUSTRIAL CO., LTD., Kadoma-shi, Osaka 571-8501 (JP)
(72) Inventor: ANDO, Takashi, Kofu-shi, Yamanashi 400 (JP); INOUE, Mamoru, Hirakata-shi, Osaka 573 (JP)
(74) Representative: Eisenführ, Speiser & Partner
(86) International application number: PCT/JP96/03804
(87) International publication number: WO 97/024912

(56) References cited:
- JP-A- 7 038 286
- JP-U- 1 024 900
- JP-U- 57 146 399

## Description

### Technical Field

The present invention relates to a component feed apparatus, and more particular, to a component feed apparatus fit for various kinds of usage, e.g., wherein a taping-component, i.e. a component tape accommodating components with a predetermined pitch in a longitudinal direction of a tape is moved along a component feed guide thereby to sequentially supply the components to a predetermined position to mount to an electronic circuit board.

### Background Art

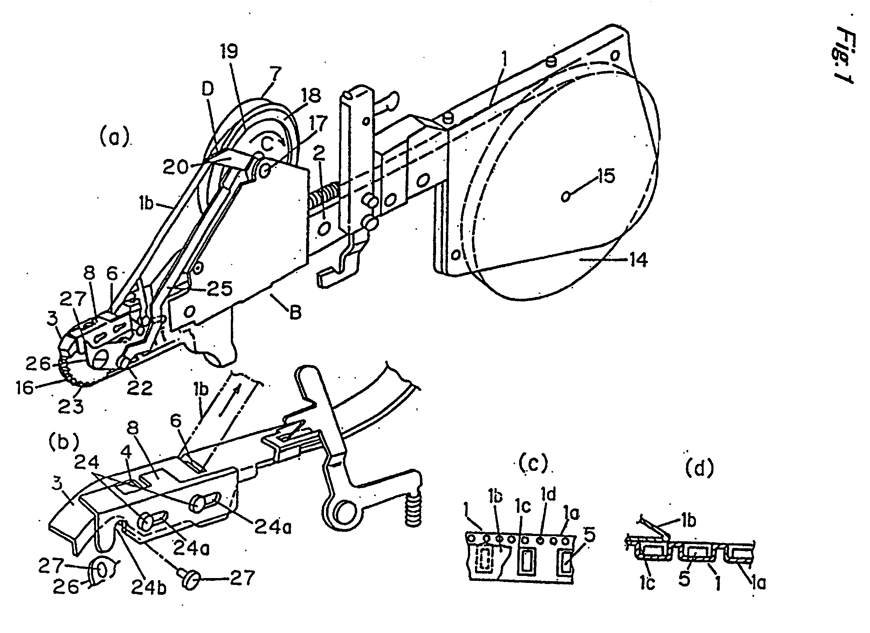

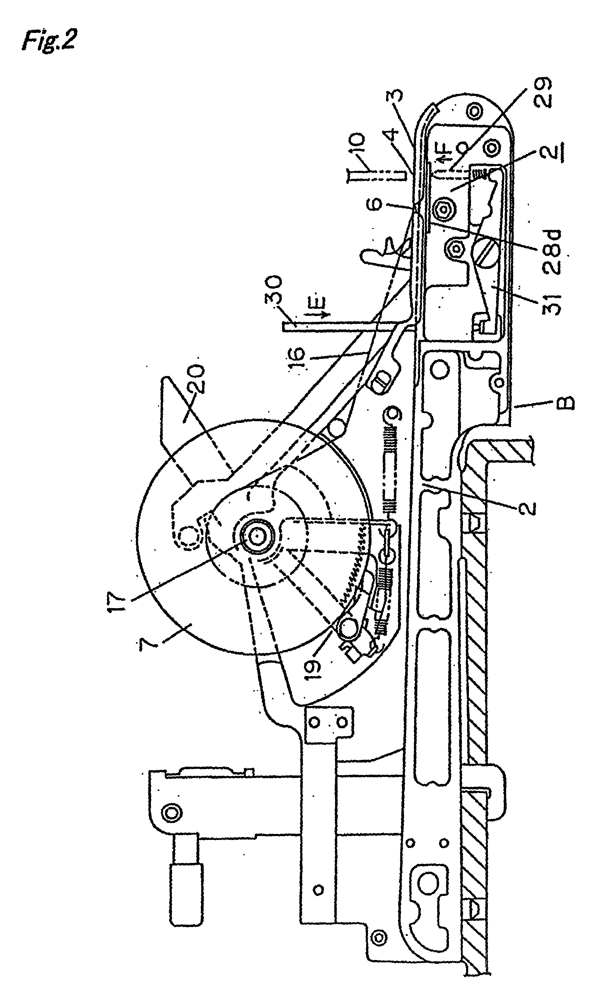

A conventional component feed apparatus will be described with reference to Figs. 1 and 2. 1 denotes a component tape which consists of component accommodating sections 1c for storing components 5 with a predetermined pitch in a longitudinal direction of a tape 1a, and a covering tape 1b covering the component accommodating sections 1c. The component tape 1 is taken out along an upper face of a component feed guide 2 and moved to a component feed port 4 of a retainer cover 3 hanging over a front end part of the component feed guide 2. During the transfer, the covering tape 1b is drawn out through a slit 6 notched from one side of the retainer cover 3 in front of the component feed port 4 and wound to a reel 7 after the covering tape 1b is separated from the tape la. The tape 1a is consequently sent to the component feed port 4, with the component accommodating sections 1c exposed. However, the exposed component accommodating sections 1c are covered with the retainer cover 3, so that the components 5 can be stably fed to the component feed port 4 without popping out.

The retainer cover 3 has a shutter 8 for preventing components 5 from popping outside unexpectedly. The shutter 8 is set in a manner to open and close an upper face of the component feed port 4 in association with an operation of feeding the components 5. Only when the components 5 are to be taken out by a suction nozzle 10 or the like, the shutter 8 is opened to allow the component 5 to be sucked by the suction nozzle 10 in a proper attitude.

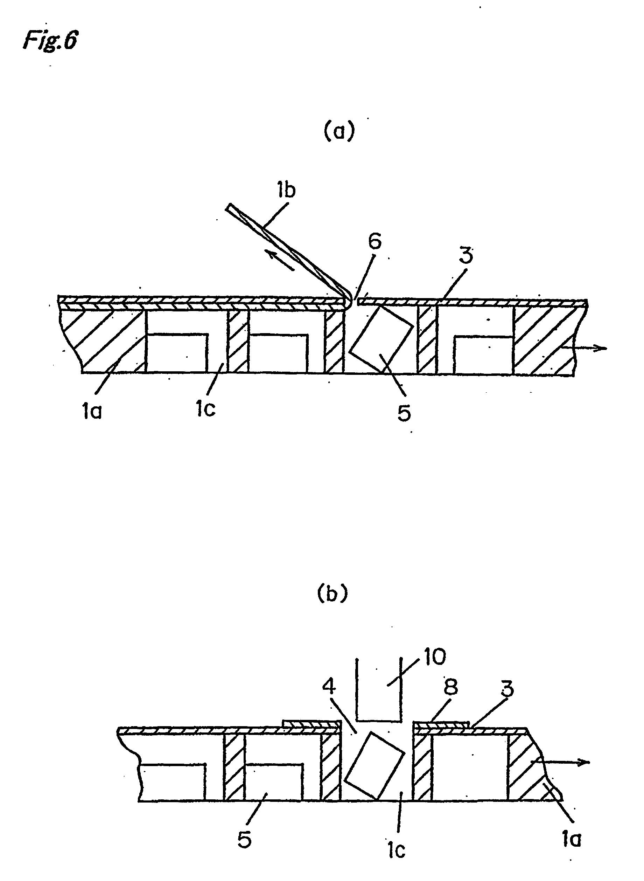

In the component feed apparatus constituted as above, the component 5 crackles with annoying static elasticity when the covering tape 1b is drawn out from the slit 6 formed in the retainer cover 3 and wound to the reel 7, as illustrated in Fig. 6(a). As a result, the component 5 is extracted and levitates out from the component accommodating section 1c as the covering tape 1b is wound up. Particularly in the case of a consider-ably minute component (for instance, much small 1.0mm length, 0.5mm breadth), the component 5 might be caught by the retainer cover 3 and might clog between the component feed guide 2 and retainer cover 3. Or the component 5 sometimes bites into the slit 6 because of vibrations and impacts, etc. at the component feed time.

As shown in Fig. 6(b), further, when the shutter 8 is opened to suck the component 5 located at the component feed port 4 by the suction nozzle 10, in some cases, the component 5 rises inside the component accommodating section 1c due to vibrations, shocks or the like in supplying components 5, whereby the component 5 cannot be sucked in a proper attitude by the suction nozzle 10. As a result, mounting errors might be occurred.

The published Japanese patent application 07 038 286 discloses a component supplying device or component feed apparatus, respectively, which forms the closest prior art from which the present application starts. This known component feed apparatus has a magnet which is provided on the carrier surface of a body part of the part supply device so that it is located on the reverse side of a tape-shaped component assembly at a component-take out position, thus attracting and fixing electronic components by magnetic force. This design prevents electronic components housed in said tape-shaped component assembly from moving even if the components supplying device vibrates due to various kinds of shocks from an electronic component mounting machine.

### Disclosure Of Invention

The main object of the present invention is therefore to provide a component feed apparatus which can stably and speedily feed components, taking into consideration with the aforementioned problems inherent in the prior art.

A component feed apparatus of the present invention comprises: a component feed guide for guiding a component tape as to be fed in one direction, the component tape including component accommodating sections for storing components with a predetermined pitch in a longitudinal direction of said tape, a covering tape with which these component accommodating sections are covered, and feed holes arranged at an equal distance; a retainer cover which can cover the component tape guided by this component feed guide; a separating means which can separate the covering tape of the component tape; a feed means for intermittently feeding the component tape in one direction; a take-up means which can take up the covering tape separated by the separating means; and a magnet for magnetically attracting components which is set at least in the vicinity of a component feed port of a component feed guide where the component is sucked, held and taken outside; wherein the magnet is further provided with an opening which lets in and out a push pin which can push up the component from below at the component feed port.

According to an invention of claim 2, in the invention of claim 1 the magnet is set immediately under the component feed port.

According to an invention of Claim 3, it is characterized in that the magnet for magnetically attracting components is set to extend from the vicinity of the separating means of the component feed guide to the vicinity of the component feed port where the component is sucked, held and taken out.

### Brief Description Of Drawings

Fig. 1 is a perspective view of a component feed apparatus and a component tape in an embodiment of the present invention.
Fig. 2 is a side view of an essential portion of the component feed apparatus of the embodiment of the present invention.
Fig. 3 is a perspective view of a mounting apparatus indicating a state when the component feed apparatus of the present invention is used.
Fig. 4 is a sectional view of the component feed apparatus of the embodiment of the present invention.
Fig. 5 is a plan view of a'component feed guide in the embodiment of the present invention.
Fig. 6 is a sectional view of an essential portion of a conventional component feed apparatus.

### Best Mode for Carrying Out the Invention

According to the present invention, in a component feed apparatus sequentially feeding components to a component feed port by moving a component tape (taping-component) along a component feed guide, is sucked by a magnetic attraction force of a magnet the component stored in a component accommodating section located in the vicinity of a separating means, so that the component is prevented from being pulled together with a covering tape when the covering tape is separated or from biting into the separating means due to vibrations or shocks, etc. at the component feed time. The component feed apparatus is effective to supply components quickly and stably.

In the constitution of the present invention the magnet installed in the vicinity of the component feed port magnetically attracts and holds the component sent to the component feed port, so that the component at the component feed port is prevented from being shifted from a proper attitude under influences of vibrations, etc. The magnet is accordingly effective to stabilize the attitude of components.

In the constitution of the present invention, during the movement of the component tape to the component feed port along the component feed guide, the magnet magnetically attracts and holds the components in the component accommodating sections, thus contributing to safety transfer of the components until the component is sucked by a suction nozzle, and moreover stabilization of the attitude of components at the component feed port.

In the constitution of the present invention, the component magnetically attracted by the magnet is pushed up from below when taken out by the suction nozzle, so that the component can be sucked more surely by the suction nozzle.

Preferred embodiments of the present invention will now be described with reference to Figs. 1, 2, 3, and 4.

### (Embodiment 1)

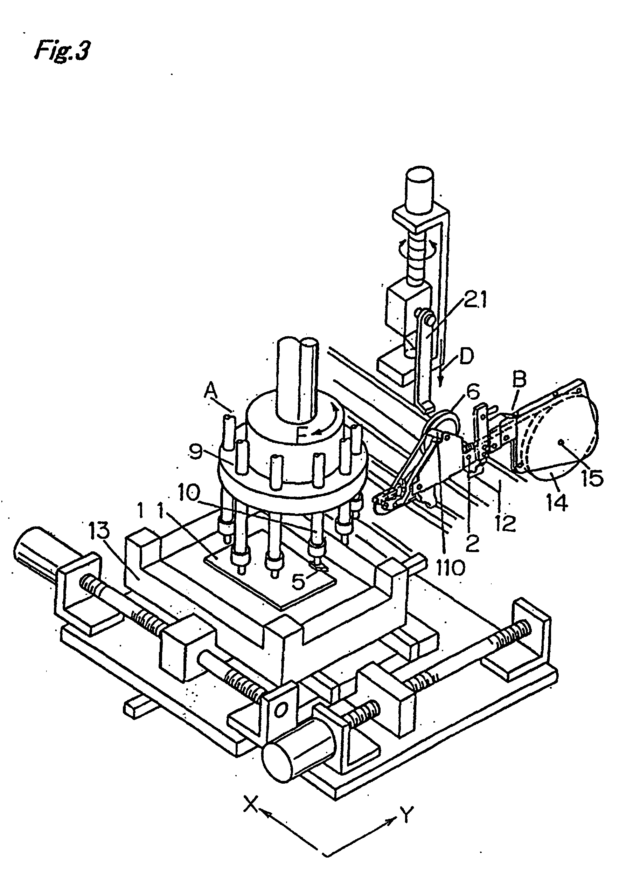

A component feed apparatus according to the Embodiment shows an example which is adopted, for instance, to automatically feed a component 5 to a printed board 11 in an electronic component mounting apparatus A as shown in Fig. 3. Needless to say, however, the component feed apparatus is generally applicable to various kinds of components. A component feed table 12 is set beside the mounting apparatus A, on which component feed apparatuses B of a count of types of components 5 required for the mounting apparatus A are loaded. The component feed apparatus B holding the components 5 of the required type at that time is moved to a position where it faces the mounting apparatus A, and the component 5 is sucked by a suction nozzle 10 at a component mounting head 9 of the mounting apparatus A and mounted to the printed board 11. The printed board 11 is placed on an XY table 13 which is movable in X, Y directions orthogonal to each other. The component 5 sucked by the suction nozzle 10 and carried to a mounting position under the movement control in the X, Y directions is mounted to a predetermined position on the printed board 11. At this time, the suction nozzle 10, instead of the printed board 11, can be moved in X, Y directions to mount the component 5 to the predetermined position of the printed board 11.

The component feed apparatus B stores each component 5 in a component accommodating section 1c provided every predetermined pitch in a longitudinal direction of a tape 1a shown at (c), (d) in Fig. 1. The apparatus B handles a component tape 1 covered with a covering tape 1b. The component tape 1 is, as indicated by (a) in Fig. 1, wound to a accommodating reel 14 which is fitted in a rotatable and detachable fashion to a supporting shaft 15 at a rear end part of a component feed guide 2.

Referring to Figs. 1 and 2, the component feed apparatus B takes out the component tape 1 wound in the accommodating reel 14 therefrom along an upper face of the component feed guide 2 and moves the component tape 1 towards a component feed port 4 through between the component feed guide 2 and a retainer cover 3 hanging over a front end part of the component feed guide 2. The component 5 is sucked and held at the component feed port 4 formed in the retainer cover 3 to be taken out therefrom.

Regarding the movement of the taped component tape 1, a sprocket 16 provided as a feed means at the front end part of the component feed guide 2 is meshed with feed holes 1d formed at the component tape 1, so that the component tape 1 is transferred through the rotation of the sprocket 16. In the middle of the movement of the component tape 1, the covering tape 1b is drawn out through a slit 6 as a separating means notched from one side of the retainer cover 3 immediately in front of the component feed port 4, then separated from the tape 1a and wound to a reel 7 as a take-up means. Although the slit is notched from one side of the retainer cover 3 is used as the separating means in the present Embodiment, any constitution can be used so long as the covering tape 1b can be drawn out.

As shown in Fig. 1(a), the reel 7 is so constructed on a supporting shaft 17 above a middle part of the component feed guide 2 as to rotate only in a take-up direction of the covering tape 1b designated by an arrow C. A ratchet mechanism 19 including a ratchet gear 18 is further provided. Every time a feed lever 20 pivotally supported to the supporting shaft 17 is pressed and turned in a direction of an arrow D by an operating mechanism 21 set at a component feed position as shown in Fig. 3, the sprocket 16 is driven via a link-lever mechanism 22 and a ratchet mechanism 23 interlocking with the link-lever mechanism 22 and the reel 7 is driven via the ratchet mechanism 19 of the reel 7. In the constitution as above, one component 5 is supplied through the movement of the component tape 1 by a predetermined distance, and simultaneously with this, the covering tape 1b is taken up by a predetermined length. Consequently, the tape 1a in a state exposing the component accommodating sections 1c subsequent to the separation of the covering tape 1b is sent to the component feed port 4.

As shown at (a), (b) in Fig. 1, a shutter 8 is provided which opens and closes the component feed port 4 to the retainer cover 3 in association with the operation of feeding of components 5, so that the components 5 are prevented from popping out unexpectedly. The shutter 8 is movably set in a front-and-rear direction by pins 24 and long holes 24a set at a bent side wall of the retainer cover 3. A downward notch 24b of the shutter 8 is engaged with a pin 27 on a lever member 26 to which the motion of the feed lever 20 of the link-lever mechanism 22 is transmitted via a link 25, when the component feed port 4 is opened in association with the feed operation of the component 5. On the other hand, the component feed port 4 is closed when the component 5 is not supplied. In other words, only when the component 5 is to be taken out by the suction nozzle 10 the shutter 8 opens to suck the component 5 and mount the component 5 to the printed board 11.

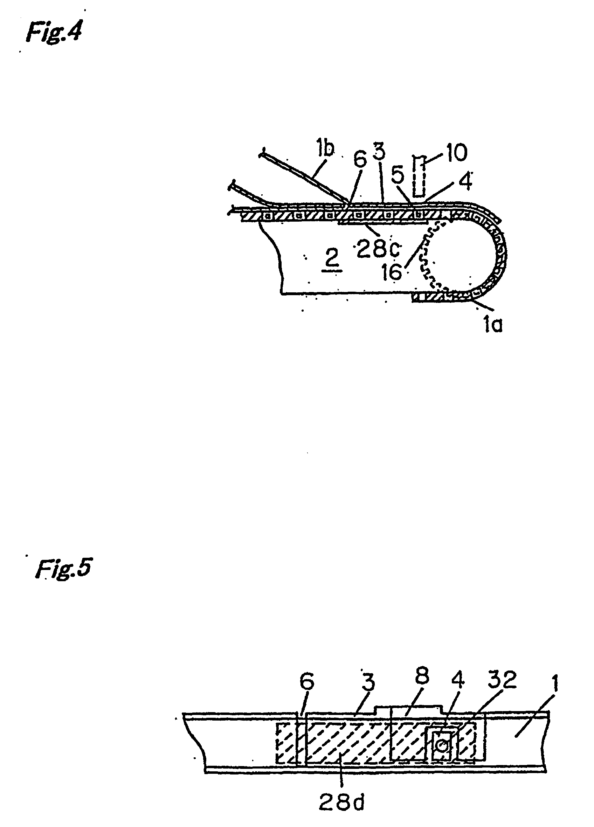

As is clear in Figs. 4 and 5, a magnet 28d of 3mm breadth, 20mm length and 1mm thickness is arranged to extend under the component feed guide 2 from the vicinity of the slit 6 where the covering tape 1b is separated to the vicinity of the component feed port 4 where the component 5 is taken out by the suction nozzle 10. The magnet 28d exerts magnetism enough (approximately 100 gauss in the present Embodiment) to stably supply the component 5 with keeping the attitude of the component 5 in accordance with a size and a mass of the component 5. The component 5 in the component accommodating section 1c is held by the magnetic attraction force of the magnet 28d during the transfer to the component feed port 4 along the component feed guide 2, and therefore the component 5 can be fed stably during the transfer thereof before the component 5 is sucked by the se nozzle 10. Moreover, the component 5 is kept stable in attitude at the component feed port 4. Although nearly 70 among 10,000 components are sucked improperly by the suction nozzle 10 in the conventional apparatus, the failure can be limited to merely 0-1 according to the present Embodiment. As a result, defective mounting to the printed board 11 can be avoided.

As indicated in Fig. 2, a push pin 29 is provided under the component feed port 4, which can push up the component 5 at the component feed port 4. In Fig. 5, a hole 32 as an opening is formed in the magnet 28d at a position corresponding to the component feed port 4. The push pin 29 can move in and out through the hole 32. When a push lever 30 is driven in a direction of an arrow E by a driving source (not illustrated), the push pin 29 is so constructed to be pushed up in a direction of an arrow F from below via a link 31.

Owing to the arrangement, even if the magnetic force of the magnet 28d extending from the vicinity of the slit 6 of the component feed guide 2 to the vicinity of the component feed port 4 is so intense as to hinder the component 5 from being taken outside by the suction nozzle 10, the component 5 can be surely sucked by the suction nozzle 10 with the help of the push pin 29 pushing the component 5 from below. A suction rate of the components by the suction nozzle 10 is improved greatly.

While the hole is provided in the present Embodiment, an opening or space allowing the push pin to move in and out, for example, a square opening may be applicable. Or the magnet may be divided via a space and the space is allotted for the push pin.

### Industrial Applicability

As described hereinabove, according to the present invention, the component feed apparatus of the present invention comprises the component feed guide for guiding a component tape to be fed in one direction, the component tape including the component accommodating sections for storing components with a predetermined pitch in a longitudinal direction of the tape, the covering tape covering these component accommodating sections and the feed holes arranged via an equal distance, the retainer cover for covering the component tape guided by this component feed guide, the separating means which can separate the covering tape of the component tape, the feed means for intermittently feeding the component tape in one direction and, the take-up means for taking up the covering tape separated by the separating means and the magnet installed in the vicinity of the component feed port magnetically attracts and holds the component carried to the component feed port, and therefore the component at the component feed port can be prevented from being shifted from a proper attitude by the influences of vibrations at the component feed time. The magnet effectively stabilizes the attitude of components.

In the constitution according to claim 1, when the component magnetically attracted by the magnet is taken outside by the suction nozzle, the component is pushed up from below, and therefore the component can be more surely sucked by the suction nozzle. A suction rate can be remarkably improved.

In the constitution according to the invention of claim 2, the magnet installed in the vicinity of the component feed port magnetically attracts and holds the component carried to the component feed port, and therefore the component at the component feed port can be prevented from being shifted from a proper attitude by the influences of vibrations at the component feed time. The magnet effectively stabilizes the attitude of components.

In the constitution according to the invention of claim 3, while the component tape is transferred to the component feed port along the component feed guide, the component in the component accommodating section is magnetically attracted and held by the magnet, and therefore the component during the transfer thereof before taken out by the suction nozzle can be fed stably. Moreover, the component can be stabilized in attitude at the component feed port, so that the component can be taken out in a proper attitude by the suction nozzle. As a result, defective mounting of components to the printed board can be eliminated.

### List of Reference Symbols of Drawings

1 ..... component tape
2 ..... component feed guide
3 ..... retainer cover
4 ..... component feed port
5 ..... component
6 ..... slit
10 .... suction nozzle
28d ... magnet
29 .... push pin

## Claims

1. A component feed apparatus, comprising:
a component feed guide (2) for guiding a component tape (1) as to be fed in one direction, said component tape (1) including component accommodating sections (1c) storing components (5) with a predetermined pitch in a longitudinal direction of the component tape (1), a covering tape (1b) covering these component accommodating sections (1c) and feed holes (1d) arranged at an equal distance;
a retainer cover (3) which can cover the component tape (1) guided by this component feed guide (2);
a separating means (6) which can strip the covering tape (1b) from the component tape (1);
a feed means (16) for intermittently feeding the component tape (1) in the one direction;
a take-up means (7) which can take up the covering tape (1c) separated by the separating means (6); and
a magnet (28d) for magnetically attracting the component (5) which is set at least in vicinity of a component feed port (4) of the component feed guide (2) where the component (5) is sucked, held and taken outside, **characterized in that** the magnet (28d) has an opening (32) through which a push pin (29) pushing up the component (5) from below at the component feed port (4), is moved in and out.

2. The component feed apparatus according to claim 1, **characterized in that** the magnet (28d) is installed immediately under the component feed port (4).

3. The component feed apparatus according to claims 1 or 2, **characterized in that** the magnet (28d) is set to extend from vicinity of the separating means (6) to vicinity of the component feed port (4) of the component feed guide (2).

## Patentansprüche

1. Bauteilzuführvorrichtung, enthaltend:
eine Bauteilzuführführung (2) zum Führen eines Bauteilbandes (1), um es in eine Richtung zuzuführen, wobei das Bauteilband (1) Bauteilaufnahmeabschnitte (1c), die Bauteile (5) aufnehmen, mit einer vorbestimmten Teilung in einer Längsrichtung des Bauteilbandes (1), ein Abdeckband (1b), welches diese Bauteilaufnahmeabschnitte (1c) abdeckt, und Förderlöcher (1d) enthält, die im gleichen Abstand angeordnet sind,
eine Rückhalteabdeckung (3), welche das Bauteilband (1) abdecken kann, das durch die Bauteilzuführführung (2) geführt ist,
ein Trennmittel (6), welches das Abdeckband (1b) von dem Bauteilband (1) abziehen kann,
ein Zuführmittel (16) zum intermittierenden Zuführen des Bauteilbandes (1) in eine Richtung,
ein Aufnahmemittel (7), welches das Abdeckband (1c), das durch das Trennmittel (6) getrennt worden ist, aufnehmen kann, und
einen Magneten (28d) zum magnetischen Anziehen des Bauteils (5), der zumindest in der Nähe einer Bauteilzuführöffnung (4) der Bauteilzuführführung (2) angeordnet ist, an der das Bauteil (5) angesaugt, gehalten und herausgenommen wird,
**dadurch gekennzeichnet, dass** der Magnet (28d) eine Öffnung (32) besitzt, durch die ein Druckstift (29), welcher das Bauteil (5) von unterhalb der Bauteilzuführöffnung (4) nach oben drückt, hinein und heraus bewegt wird.

2. Bauteilzuführvorrichtung nach Anspruch 1,
**dadurch gekennzeichnet, dass** der Magnet (28d) unmittelbar unter der Bauteilzuführöffnung (4) angeordnet ist.

3. Bauteilzuführvorrichtung nach Anspruch 1 oder 2,
**dadurch gekennzeichnet, dass** der Magnet (28d) angeordnet ist, um sich aus der Nähe des Trennmittels (6) zu der Nähe der Bauteilzuführöffnung (4) der Bauteilzuführführung (2) zu erstrecken.

## Revendications

1. Appareil d'alimentation en composants, comprenant :
un guide d'alimentation en composants (2) pour guider une bande de composants (1) qui doit être délivrée dans une première direction, ladite bande de composants (1) comportant des sections de réception de composants (1c) stockant des composants (5) avec un pas prédéterminé dans une direction longitudinale de la bande de composants (1), une bande de couverture (1b) recouvrant ces sections de réception de composants (1c) et des trous d'alimentation (1d) disposés à une distance égale ;
un couvercle de retenue (3) qui peut recouvrir la bande de composants (1) guidée par ce guide d'alimentation en composants (2) ;
des moyens de séparation (6) qui peuvent détacher la bande de couverture (1b) de la bande de composants (1);
des moyens d'alimentation (16) pour avancer de manière intermittente la bande de composants (1) dans la première direction ;
des moyens de récupération (7) qui peuvent récupérer la bande de couverture (1c) séparée par les moyens de séparation (6) ; et
un aimant (28d) pour attirer magnétiquement le composant (5) qui est placé au moins au voisinage d'un orifice d'alimentation en composants (4) du guide d'alimentation en composants (2) où le composant (5) est aspiré, maintenu et sorti, **caractérisé en ce que** l'aimant (28d) comporte une ouverture (32) à travers laquelle une broche de poussée (29) poussant le composant (5) vers le haut à partir du bas, au niveau de l'orifice d'alimentation en composants (4), est entrée et sortie.

2. Appareil d'alimentation en composants selon la revendication 1, **caractérisé en ce que** l'aimant (28d) est installé immédiatement sous l'orifice d'alimentation en composants (4).

3. Appareil d'alimentation en composants selon la revendication 1 ou 2, **caractérisé en ce que** l'aimant (28d) est positionné pour s'étendre depuis le voisinage des moyens de séparation (6) jusqu'au voisinage de l'orifice d'alimentation en composants (4) du guide d'alimentation en composants (2).
